(19) Europäisches Patentamt
European Patent Office
Office européen des brevets

(11) **EP 4 309 828 A1**

(12) **EUROPEAN PATENT APPLICATION**
published in accordance with Art. 153(4) EPC

(43) Date of publication:
**24.01.2024  Bulletin 2024/04**

(21) Application number: **22771366.6**

(22) Date of filing: **14.03.2022**

(51) International Patent Classification (IPC):
**B22F 1/102** (2022.01)    **B22F 1/00** (2022.01)
**B22F 7/08** (2006.01)     **B22F 9/00** (2006.01)
**C09K 5/14** (2006.01)     **H01B 1/00** (2006.01)
**H01B 1/22** (2006.01)

(52) Cooperative Patent Classification (CPC):
**B22F 1/00; B22F 1/102; B22F 7/08; B22F 9/00;
C09K 5/14; H01B 1/00; H01B 1/22**

(86) International application number:
**PCT/JP2022/011246**

(87) International publication number:
**WO 2022/196620 (22.09.2022 Gazette 2022/38)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **17.03.2021  JP 2021043526**

(71) Applicant: **Kyocera Corporation
Kyoto-shi Kyoto 612-8501 (JP)**

(72) Inventors:
• **KIKUCHI, Tomonao**
  **Kyoto-shi, Kyoto 612-8501 (JP)**
• **NONOMURA, Kouki**
  **Kyoto-shi, Kyoto 612-8501 (JP)**

(74) Representative: **Viering, Jentschura & Partner
mbB
Patent- und Rechtsanwälte
Am Brauhaus 8
01099 Dresden (DE)**

(54) **PASTE COMPOSITION, SEMICONDUCTOR DEVICE, ELECTRICAL COMPONENT AND ELECTRONIC COMPONENT**

(57)    A paste composition including first copper particles, wherein the first copper particles are formed by covering copper particles serving as a base material with at least one type of compound selected from the group consisting of an amine compound (a) and a carboxylic acid amine salt (b), and a total content of the amine compound (a) and the carboxylic acid amine salt (b) detected in the paste composition is less than 1 mass% of an entire amount of the paste composition.

EP 4 309 828 A1

**Description**

TECHNICAL FIELD

The present disclosure relates to a paste composition and a semiconductor device, an electrical component, and an electronic component joined by the paste composition.

BACKGROUND OF INVENTION

As semiconductor productions become larger in capacity, higher in processing speed, and finer in wiring, the semiconductor productions generate a large amount of heat during operation. The dissipation of heat from semiconductor products, so-called thermal management, is becoming increasingly important. For this reason, commonly employed is a method of attaching a heat dissipation member such as a heat spreader or a heat sink to a semiconductor product. The material for bonding the heat dissipation member is desired to have higher thermal conductivity.

In some cases, semiconductor elements are bonded to an organic substrate having a heat dissipation mechanism such as a thermal via. Also in this case, the material for bonding semiconductor elements is required to have high thermal conductivity. In addition, due to the recent increase in luminance of white light-emitting LEDs, materials for bonding semiconductor elements have been widely used in lighting devices such as backlight illumination, ceiling light, and downlight for full-color liquid crystal screens. With high current input due to high output of light-emitting elements, an adhesive between a light-emitting element and a substrate is discolored by heat, light, or the like, or an electrical resistance value changes with time. In particular, in the method in which the joining between a light-emitting element and a substrate depends on an adhesive, a joining material may peel off at the solder melting temperature during the solder mounting of electronic components, resulting in non-lighting in some cases. In addition, as the performance of white light-emitting LEDs improves, the amount of heat generated by light-emitting element chips increases. Thus, the structure of LEDs and members used in LEDs are also required to have improved heat dissipation properties.

In particular, in recent years, power semiconductor devices using a wide band gap semiconductor element such as silicon carbide (SiC) or gallium nitride (GaN) having a small power loss have been actively developed. These elements have high heat resistance and can be operated at a high temperature not less than 250°C with a large current. To exhibit such characteristics, efficient dissipation of heat generated in operation is required, and a joining material having long-term and high-temperature heat resistance in addition to electrical conductivity and thermal conductivity is required.

As described above, a die attach paste, a material for bonding a heat dissipation member, and the like used for bonding each member of a semiconductor device, an electrical component, and an electronic component are required to have high thermal conductivity. At the same time, these materials need to be resistant to reflow treatment during mounting of the product on the substrate.

As a paste material capable of withstanding such a demand, a joining method using silver nanoparticles has been attracting attention, which enables joining at a temperature lower than that of bulk silver (see, for example, Patent Document 1).

Silver particles have very high conductivity, but due to their high price and migration difficulties, replacement with other metals has been studied. Thus, copper particles which are less expensive than silver particles and have migration resistance are attracting attention.

A joining material containing copper nanoparticles and copper microparticles and/or copper submicroparticles has been proposed (for example, see Patent Document 2).

CITATION LIST

PATENT LITERATURE

Patent Document 1: JP 2011-240406 A
Patent Document 2: JP 2014-167145 A

SUMMARY

[1] A paste composition of the present disclosure is a paste composition including first copper particles, wherein

the first copper particles are formed by covering copper particles serving as a base material with at least one compound selected from the group consisting of an amine compound (a) and a carboxylic acid amine salt (b), and a total content of the amine compound (a) and the carboxylic acid amine salt (b) detected in the paste composition is less than 1 mass% of an entire amount of the paste composition.

[2] A semiconductor device of the present disclosure is joined by using the paste composition described in [1].

[3] an electrical component of the present disclosure is joined by using the paste composition described in [1].

[4] an electronic component of the present disclosure is joined by using with the paste composition described in [1].

BRIEF DESCRIPTION OF THE DRAWINGS

FIG. 1 is a cross-sectional view of a semiconductor device according to an embodiment of the present disclosure.

FIG. 2 is a cross-sectional view of an electrical component according to an embodiment of the present disclosure.

DESCRIPTION OF EMBODIMENTS

The time for copper paste containing sinterable copper nanoparticles to cure is longer than that of a solder paste because of the principle of joining. Thus, the copper paste requires a waiting time after mounting an adherend until the copper paste is charged into a curing furnace. In the copper paste containing sinterable copper nanoparticles, oxidation of the surfaces of the copper nanoparticles may proceed during this waiting time, resulting in a decrease in joining reliability.

The present disclosure provides a paste composition that has oxidation resistance and maintains high sinterability and joinability without being affected by the atmospheric exposure time before curing, and a semiconductor device, an electrical component, and an electronic component having high reliability with the use of the paste composition.

Hereinafter, the present disclosure will be described in detail with reference to an embodiment.

Paste Composition

A paste composition of the present embodiment includes first copper particles formed by covering copper particles serving as a base material with at least one type of compound selected from the group consisting of an amine compound (a) and a carboxylic acid amine salt (b), and a total content of the amine compound (a) and the carboxylic acid amine salt (b) detected in the paste composition is less than 1 mass% of an entire amount of the paste composition.

When the total content of the amine compound (a) and the carboxylic acid amine salt (b) detected in the paste composition of the present embodiment is not less than 1 mass% of the entire amount of the paste composition, the paste composition has low sinterability and joinability, and the sinterability and j oinability after atmospheric exposure may decrease. From such a viewpoint, the total content of the amine compound (a) and the carboxylic acid amine salt (b) may be less than 0.8 mass%, may be less than 0.5 mass%, or may be less than 0.3 mass%.

The amine compound (a) and the carboxylic acid amine salt (b) are blended at the time of synthesis of the first copper particles. Although the amine compound (a) and the carboxylic acid amine salt (b) cover the surfaces of the first copper particles, they may be present in a free state in the paste composition without completely covering the surfaces. An amine compound may be added as a reducing agent. When the total content of the amine compound (a) and the carboxylic acid amine salt (b) in the paste composition is equal to or greater than the above value, the amine compound (a) and the carboxylic acid amine salt (b) are unevenly distributed in the paste composition at the time of curing of the paste composition, and sinterability of the first copper particles is deteriorated. As a result, the stability of the first copper particles after atmospheric exposure decreases.

The total content of the amine compound (a) and the carboxylic acid amine salt (b) in the paste composition can be measured by a chromatography method represented by gas chromatography, liquid chromatography, or the like, or a method combining mass spectrometry with the chromatography method. Specifically, the total content of the amine compound (a) and the carboxylic acid amine salt (b) in the paste composition can be measured by the method described in the examples.

First Copper Particle

The first copper particles used in the present embodiment is formed by covering copper particles serving as a base material with at least one type of compound selected from the group consisting of an amine compound (a) and a carboxylic acid amine salt (b). The first copper particles may be covered with the carboxylic acid amine salt (b) from the viewpoint of uniformizing the sintering rate and the sintering degree between the inside of a joining layer and a fillet and improving the joining characteristics.

The copper particles serving as the base material of the first copper particles are derived from a copper compound. The copper compound is subjected to no particular limitation as long as the compound contains a copper atom. Examples of the copper compound include copper carboxylate, copper oxide, copper hydroxide, and copper nitride. The copper compound may be copper carboxylate from the viewpoint of uniformity during the reaction. These may be used alone or in combination of two or more.

Examples of the copper carboxylate include copper carboxylic anhydrides or copper carboxylate hydrates of copper (I) formate, copper (I) acetate, copper (I) propionate, copper (I) butyrate, copper (I) valerate, copper (I) caproate, copper (I) caprylate, copper (I) caprate, copper (II) formate, copper (II) acetate, copper (II) propionate, copper (II) butyrate, copper (II) valerate, copper (II) caproate, copper (II) caprylate, copper (II) caprate, copper (II) citrate, or the like. The copper carboxylate may be a copper (II) acetate monohydrate from the viewpoint of productivity and ease of availability. In addition, these may be used alone or in combination of two or more.

As the copper carboxylate, a commercially available copper carboxylate may be used, or a copper carboxylate produced by synthesis may be used.

The copper carboxylate may be synthesized by a known method, for example, by mixing and/or heating copper (II) hydroxide and a carboxylic acid compound.

Examples of the copper oxide include copper (II) oxide and copper (I) oxide, and copper (I) oxide may be used from the viewpoint of productivity. Examples of the copper hydroxide include copper (II) hydroxide and copper (I) hydroxide.

These may be used alone or in combination of two or more.

The at least one type of compound selected from the group consisting of an amine compound (a) and a carboxylic acid amine salt (b) may cover a part of the surface of the copper particles which are the base material of the first copper particles or may cover the entire surface of the copper particles.

From the viewpoint of sinterability and joinability, the mass coverage of the first copper particles with the at least one type of compound selected from the group consisting of an amine compound (a) and a carboxylic acid amine salt (b) covering the surface of copper particles serving as the base material may be not less than 0.05%, may be not less than 0.1%, may be not less than 0.2%, or may be not less than 0.5%. The upper limit value of the mass coverage may be 10%, may be 7%, may be 5%, or may be 3%. When the mass coverage is not greater than 10%, the content of the amine compound (a) and the carboxylic acid amine salt (b) detected in the paste composition containing the first copper particles can be easily made less than 1 mass% of the entire amount of the paste composition.

In the present disclosure, the mass coverage is defined as the mass reduction rate calculated from the mass of the first copper particles before heating and the mass of the first copper particles after heating with an infrared lamp heating device or the like. Specifically, the mass coverage can be measured by the method described in Examples.

Examples of the amine compound (a) used in the present embodiment include a monoamine having one amino group and a diamine having two amino groups. Examples of the monoamine include dipropylamine, butylamine, dibutylamine, hexylamine, cyclohexylamine, heptylamine, octylamine, nonylamine, decylamine, 3-aminopropyltriethoxysilane, dodecylamine, oleylamine, monoethanolamine, 3-amino-1-propanol, and 3-amino-2-propanol. Examples of the diamine include ethylenediamine, N,N-dimethylethylenediamine, N,N'-dimethylethylenediamine, N,N-diethylethylenediamine, N,N'-diethylethylenediamine, 1,3-propanediamine, 2,2-dimethyl-1,3-propanediamine, N,N-dimethyl-1,3-diaminopropane, N,N'-dimethyl-1,3-diaminopropane, N,N-diethyl-1,3-diaminopropane, 1,4-diaminobutane, 1,5-diamino-2-methylpentane, 1,6-diaminohexane, N,N'-dimethyl-1,6-diaminohexane, 1,7-diaminoheptane, and 1,8-diaminooctane.

The carboxylic acid amine salt (b) used in the present embodiment can be produced from a carboxylic acid compound and an amine compound, and a commercially available product may be used. A carboxylic acid amine salt produced by synthesis in advance may also be used. The carboxylic acid amine salt may be produced in situ by separately charging a carboxylic acid compound and an amine compound into a reaction vessel in the process of producing the first copper particles.

The carboxylic acid amine salt is produced by blending a carboxylic acid compound and an amine compound in an equivalent amount of functional groups in an organic solvent and mixing at relatively mild temperature conditions of room temperature (25°C) to approximately 100°C. The carboxylic acid amine salt may be taken out from a reaction solution containing the carboxylic acid amine salt by distillation, recrystallization, or the like.

The carboxylic acid compound constituting the carboxylic acid amine salt is any compound having a carboxy group and is not particularly limited, and examples include monocarboxylic acids, dicarboxylic acids, aromatic carboxylic acids, and hydroxy acids. The carboxylic acid compound may be a monocarboxylic acid or a dicarboxylic acid from the viewpoint of sinterability. These may be used alone or in combination of two or more.

The thermal decomposition temperature of the carboxylic acid compound constituting the carboxylic acid amine salt may be not higher than 200°C, may be not higher than 190°C, or may be not higher than 180°C from the viewpoint of sinterability.

When the carboxylic acid compound constituting the carboxylic acid amine salt has a boiling point lower than the thermal decomposition temperature, the boiling point may be not higher than 280°C, may be not higher than 260°C, or may be not higher than 240°C from the viewpoint of sinterability.

Examples of the monocarboxylic acid among the carboxylic acid compounds constituting the carboxylic acid amine salt include formic acid, acetic acid, propionic acid, butyric acid, valeric acid, caproic acid, caprylic acid (octanoic acid), octylic acid, nonanoic acid, capric acid (decanoic acid), oleic acid, stearic acid, and isostearic acid. These may be used alone or in combination of two or more. From the viewpoint of sinterability, the monocarboxylic acid may be formic acid, acetic acid, propionic acid, butyric acid, valeric acid, caproic acid, caprylic acid, octylic acid, nonanoic acid, or capric acid, or may be valeric acid, caproic acid, caprylic acid, octylic acid, nonanoic acid, or capric acid.

Examples of the dicarboxylic acid among the carboxylic acid compounds constituting the carboxylic acid amine salt include oxalic acid, malonic acid, succinic acid, glutaric acid, adipic acid, pimelic acid, suberic acid, azelaic acid, sebacic acid, and diglycolic acid. These may be used alone or in combination of two or more. From the viewpoint of sinterability, the dicarboxylic acid may be oxalic acid, malonic acid, succinic acid, glutaric acid, adipic acid, or diglycolic acid, or may be oxalic acid, malonic acid, succinic acid, or diglycolic acid.

Examples of the aromatic carboxylic acid among the carboxylic acid compounds constituting the carboxylic acid amine salt include benzoic acid, phthalic acid, isophthalic acid, terephthalic acid, salicylic acid, and gallic acid. These may be used alone or in combination of two or more. The aromatic carboxylic acid may be benzoic acid from the viewpoint of sinterability.

Examples of the hydroxy acid among the carboxylic acid compounds constituting the carboxylic acid amine salt include glycolic acid, lactic acid, tartronic acid, malic acid, glyceric acid, hydroxybutyric acid, tartaric acid, citric acid, and isocitric acid. These may be used alone or in combination of two or more. From the viewpoint of sinterability, the hydroxy acid may be glycolic acid, lactic acid, or malic acid.

The amine compound constituting the carboxylic acid amine salt is any compound having an amino group and is not particularly limited, and examples include alkylmonoamines, alkyldiamines, and alkanolamines. These may be used alone or in combination of two or more. The amine compound may be an alkylmonoamine or alkanolamine from the viewpoint of enhancing sinterability.

Examples of the alkylmonoamine among the amine compounds constituting the carboxylic acid amine salt include methylamine, ethylamine, propylamine, butylamine, hexylamine, octylamine, decylamine, and dodecylamine. These may be used alone or in combination of two or more. The alkylmonoamine may be hexylamine, octylamine, or decylamine from the viewpoint of enhancing sinterability.

Examples of the alkyldiamine among the amine compounds constituting the carboxylic acid amine salt include 1,1-methanediamine, 1,2-ethanediamine, 1,3-propanediamine, 1,4-butanediamine, 1,6-hexanediamine, and 1,8-octanediamine. These may be used alone or in combination of two or more. The alkyldiamine may be 1,4-butanediamine or 1,6-hexanediamine from the viewpoint of enhancing sinterability.

Examples of the alkanolamine among the amine compounds constituting the carboxylic acid amine salt include monoethanolamine, monopropanolamine, monobutanolamine, 2-(2-aminoethylamino)ethanol, 2-(2-aminoethoxy)ethanol, 1-amino-2-propanol, 2-amino-1-propanol, and 3-amino-1,2-propanediol. These may be used alone or in combination of two or more. The alkanolamine may be monoethanolamine, monopropanolamine, monobutanolamine, 1-amino-2-propanol, or 2-amino-1-propanol from the viewpoint of enhancing sinterability.

The median diameter (D50) of the first copper particles may be not less than 50 nm and not more than 500 nm, may be not less than 55 nm and not more than 400 nm, may be not less than 60 nm and not more than 300 nm, or may be not less than 60 nm and not more than 200 nm from the viewpoint of lowering of oxidation and denseness of a joining layer. As the median diameter becomes smaller, the specific surface area tends to be larger, and oxidation tends to occur more easily.

The median diameter of the first copper particles is calculated as a median of area equivalent circle diameters of at least 2000 copper particles extracted from an image photographed under the conditions of an acceleration voltage of 15 kV and 50000 times by a scanning electron microscope (SEM, for example, trade name: JSM-F100, available from JEOL Ltd.). Specifically, the median diameter of the first copper particles can be measured by the method described in the examples.

The first copper particles may have a crystallite diameter not less than 30 nm and not more than 150 nm, more than 50 nm and not more than 120 nm, or more than 50 nm and not more than 100 nm. When the crystallite diameter is not less than 30 nm, oxidation due to atmospheric exposure is unlikely to occur, and sintering is stable. When the crystallite diameter is not more than 150 nm, low-temperature sinterability can be ensured.

In the present disclosure, the crystallite diameter is calculated with the Scherrer method using the Cu (111) peak determined by X-ray diffraction (XRD) measurement. Specifically, the crystallite diameter can be measured by the method described in the examples.

The first copper particles may have an oxidation degree not less than 0.01% and not greater than 3.0%, not less than 0.02% and not greater than 2.6%, not less than 0.05% and not greater than 2.5%, and not less than 0.1% and not greater than 2.0%. When the oxidation degree is not less than 0.01%, oxidation due to exposure to the air is unlikely to occur, and sintering is stable. When the oxidation degree is not greater than 3.0%, sinterability improves. The oxidation degree may be determined, for example, by analyzing data collected using an X-ray diffractometer with the Rietveld method. Specifically, the oxidation degree can be measured by the method described in the examples.

The content of the first copper particles may be not less than 10 mass% and not greater than 90 mass%, may be not less than 10 mass% and not greater than 60 mass%, or may be not less than 10 mass% and not greater than 40 mass% with respect to the total amount of the paste composition.

Method for Producing First Copper Particle

Examples of a method for producing the first copper particles include a method including reducing a copper compound with a reducing compound in the presence of at least one type of compound selected from the group consisting of an amine compound (a) and a carboxylic acid amine salt (b).

As the copper compound, the amine compound (a), and the carboxylic acid amine salt (b), those described in the section of First Copper Particle may be used.

The reducing compound is subjected to no particular limitation as long as the reducing compound has a reducing power to reduce the copper compound and release metallic copper. Examples of the reducing compound include a hydrazine derivative. Examples of the hydrazine derivative include hydrazine monohydrate, methylhydrazine, ethylhydrazine, n-propylhydrazine, i-propylhydrazine, n-butylhydrazine, i-butylhydrazine, sec-butylhydrazine, t-butylhydrazine, n-pentylhydrazine, i-pentylhydrazine, neo-pentylhydrazine, t-pentylhydrazine, n-hexylhydrazine, i-hexylhydrazine, n-heptylhydrazine, n-octylhydrazine, n-nonylhydrazine, n-decylhydrazine, n-undecylhydrazine, n-dodecylhydrazine, cyclohexylhydrazine, phenylhydrazine, 4-methylphenylhydrazine, benzylhydrazine, 2-phenylethylhydrazine, 2-hydrazinoethanol, and acetohydrazine. These may be used alone or in combination of two or more.

The copper compound, the at least one type of compound selected from the group consisting of an amine compound (a) and a carboxylic acid amine salt (b), and the reducing compound may be mixed in an organic solvent.

The organic solvent may be used without particular limitation as long as the organic solvent can be used as a reaction solvent not inhibiting properties of a complex or the like generated from a mixture produced by mixing the above-described raw materials. The organic solvent may be, in particular, an alcohol exhibiting compatibility with the reducing compound.

Examples of the alcohol include 1-propanol, 2-propanol, butanol, pentanol, hexanol, heptanol, octanol, ethylene glycol, 1,3-propanediol, 1,2-propanediol, butyl carbitol, butyl carbitol acetate, ethyl carbitol, ethyl carbitol acetate, diethylene glycol diethyl ether, and butyl cellosolve. These may be used alone or in combination of two or more.

The order of mixing these compounds is subjected to no particular limitation, and the compounds may be mixed in any order. For example, the copper compound and the at least one type of compound selected from the group consisting of an amine compound (a) and a carboxylic acid amine salt (b) may be mixed at a temperature not less than 0°C and not higher than 110°C for about a period not less than 5 minutes and not more than 30 minutes, and then the reducing compound may be further added and mixed.

In the mixing, as the amounts of the copper compound, the at least one type of compound selected from the group consisting of an amine compound (a) and a carboxylic acid amine salt (b), and the reducing compound to be used, the amount of the at least one type of compound selected from the group consisting of an amine compound (a) and a carboxylic acid amine salt (b) may be not less than 0.5 mol and not more than 10 mol, and the amount of the reducing compound may be not less than 0.5 mol and not more than 5 mol with respect to 1 mol of the copper compound; or the amount of the at least one type of compound selected from the group consisting of an amine compound (a) and a carboxylic acid amine salt (b) may be not less than 1 mol and not more than 5 mol, and the amount of the reducing compound may be not less than 0.8 mol and not more than 3 mol with respect to 1 mol of the copper compound.

The amount of the organic solvent may be an amount with which the components can sufficiently react with each other. For example, the organic solvent may be used in an approximate amount not less than 10 volumes and not more than 1000 volumes with respect to 100 volumes of the at least one type of compound selected from the group consisting of an amine compound (a) and a carboxylic acid amine salt (b).

Next, the mixture produced by mixing is sufficiently heated to cause the reduction reaction of the copper compound to proceed. This heating can eliminate the unreacted copper compound and can satisfactorily deposit and grow metallic copper to form copper particles. The heating temperature of the mixture may be not less than 25°C and not higher than 120°C, may be not less than 50°C and not higher than 120°C, or may be not less than 80°C and not higher than 120°C. The heating time may be not less than 20 minutes and not more than 360 minutes, may be not less than 30 minutes and not more than 300 minutes, or may be not less than 40 minutes and not more than 240 minutes. When the heating temperature and the heating time are within the above ranges, the oxidation degree of the resulting first copper particles can be easily controlled within the above-described range.

The solid precipitated with the heating may be separated from excess amine compound (a) and/or carboxylic acid amine salt (b) by centrifugation or the like, then washed with an organic solvent, and dried under reduced pressure.

The first copper particles may be produced through such an operation.

The washing may be appropriately adjusted by the number of times of washing, the amount of the organic solvent to be used, the washing time, and the like, and the oxidation degree of the first copper particles thus produced may be adjusted to fall within the above-described range. The number of times of washing may be, for example, not less than 2 and not greater than 20, may be not less than 3 and not greater than 16, may be not less than 4 and not greater than 12, or may be not less than 5 and not greater than 10.

The amount of the organic solvent to be used may be not less than 10 vol%, may be not less than 100 vol%, or may be not less than 1000 vol% in a volume ratio with respect to the first copper particles, for example.

The washing time may be not less than 1 minute and not more than 40 minutes, may be not less than 3 minutes and not more than 35 minutes, or may be not less than 5 minutes and not more than 30 minutes.

Here, the washing reduces the contents of impurities such as the amine compound (a) and the carboxylic acid amine salt (b) in the paste composition containing the first copper particles but increases the oxidation degree of the first copper particles as the number of times of washing increases. Thus, the total content of the amine compound (a) and the carboxylic acid amine salt (b) in the paste composition needs to be controlled to be less than the above-described value and the oxidation degree of the first copper particles needs to be controlled to be in the above-described range by appropriately adjusting the washing.

Second Copper Particle

From the viewpoint of storage stability, the paste composition of the present embodiment may further contain second copper particles having a larger particle diameter than the first copper particles.

The second copper particles may have a median diameter (D50) not less than 1 $\mu$m and not more than 8 $\mu$m, not less than 1.5 $\mu$m and not more than 7 $\mu$m, or not less than 2 $\mu$m and not more than 6 $\mu$m. Having the median diameter within the above range reduces internal shrinkage at the time of sintering and improves sinterability with the joining interface (dissimilar metal), achieving improved joint strength.

The second copper particles may have a crystallite diameter not less than 70 nm and not more than 140 nm, not less than 75 nm and not more than 130 nm, or not less than 80 nm and not more than 120 nm. Having the crystallite diameter within the above range reduces the internal shrinkage during sintering and improves the sinterability with the joining interface (dissimilar metal), achieving improved joint strength.

The second copper particles may be used alone or in combination of two or more types.

The median diameter of the second copper particles is based on the number and can be measured using a laser diffraction scattering type particle size distribution measuring apparatus or the like.

The shape of the second copper particles is subjected to no particular limitation, and examples thereof include a spherical shape, a plate shape, a flake shape, a scale shape, a dendritic shape, a rod shape, and a wire shape.

As the second copper particles, a commercially available product may be used, and examples thereof include 1200Y (manufactured by Mitsui Mining & Smelting Co., Ltd., median diameter: 2.1 $\mu$m, crystallite diameter: 102 nm) and 1300Y (manufactured by Mitsui Mining & Smelting Co., Ltd., median diameter: 3.9 $\mu$m, crystallite diameter: 102 nm).

The content of the second copper particles may be not less than 10 mass% and not greater than 90 mass%, may be not less than 10 mass% and not greater than 70 mass%, or may be not less than 20 mass% and not greater than 60 mass% with respect to the total amount of the paste composition.

Phosphoric Acid Ester

The paste composition of the present embodiment may further contain a phosphoric acid ester from the viewpoint of storage stability. Since a phosphoric acid ester has an action of removing the oxide film on the surface of the first copper particles generated because of atmospheric exposure during heating, the paste composition containing a phosphoric acid ester has enhanced sinterability. The action of the phosphoric acid ester is not reduced as long as the total content of the amine compound (a) and the carboxylic acid amine salt (b) contained in the paste composition of the present embodiment is less than the above value.

The phosphoric acid ester may have an acid value and an amine value each being not greater than 130 mgKOH/g, not greater than 120 mgKOH/g, or not greater than 110 mgKOH/g. When each of the acid value and the amine value of the phosphoric acid ester is not greater than the above-described values, a change in the oxidation degree of the first copper particles can be minimized. Here, the acid value (mgKOH/g) can be calculated in accordance with JIS K 0070:1992, and the amine value can be calculated in accordance with JIS K 7237:1995.

The phosphoric acid ester may have a ratio of the acid value to the amine value [acid value/amine value] that is not less than 0 and not greater than 1.5, or not less than 0 and not greater than 1.2. Having the ratio [acid value/amine value] within the above range can reduce a change in the oxidation degree of the first copper particles.

Examples of the phosphoric acid ester include alkyl phosphates, polyoxyethylene alkyl ether phosphates, and polyoxyethylene alkyl phenyl ether phosphates. More specific examples of the phosphoric acid ester include DISPERBYK (registered trademark; hereinafter, description is omitted)-102 (acid value: 101 mgKOH/g), DISPERBYK-111 (acid value: 129 mgKOH/g), DISPERBYK-145 (acid value: 76 mgKOH/g, amine value: 71 mgKOH/g), DISPERBYK-180 (acid value: 94 mgKOH/g, amine value: 94 mgKOH/g), DISPERBYK-185 (amine value: 17 mgKOH/g), DISPERBYK-190 (acid value: 10 mgKOH/g), and DISPERBYK-2155 (amine value: 48 mgKOH/g).

When the paste composition of the present embodiment contains a phosphoric acid ester, the content thereof may be not less than 0.01 mass% and not greater than 2.0 mass%, may be not less than 0.1 mass% and not greater than 1.8 mass%, or may be not less than 0.5 mass% and not greater than 1.5 mass% with respect to the total amount of the paste composition.

The paste composition of the present embodiment may contain an organic solvent. The organic solvent may be an alcohol, and examples thereof include an aliphatic polyhydric alcohol. Examples of the aliphatic polyhydric alcohol include glycols, such as ethylene glycol, diethylene glycol, propylene glycol, dipropylene glycol, 1,4-butanediol, glycerin, and polyethylene glycol. These organic solvents may be used alone or in combination of two or more types.

When the paste composition of the present embodiment contains an organic solvent, the content thereof may be not less than 10 parts by mass and not more than 50 parts by mass, or may be not less than 20 parts by mass and not more than 40 parts by mass based on 100 parts by mass of the first copper particles. Having the content not less than 10 parts by mass, with which the viscosity does not become too high, can improve workability. Having the content not more than 50 parts by mass can reduce the viscosity reduction, reduce settling of the copper in the paste composition, and improve reliability.

In the paste composition of the present embodiment, in addition to the above components, a thermosetting resin, a curing accelerator, a stress reducing agent such as rubber and silicone, a coupling agent, an antifoaming agent, a surfactant, a colorant such as a pigment and a dye, a polymerization inhibitor, an antioxidant, and other various additives that are commonly blended in this type of composition can be blended as necessary. Each of these additives may be used alone, or two or more may be mixed and used.

Method for Producing Paste Composition

The paste composition of the present embodiment may be prepared by sufficiently mixing the first copper particles described above and, as necessary, additives such as the second copper particles, a phosphoric acid ester, an organic solvent, a thermosetting resin, a coupling agent, and the like, then further performing a kneading treatment with a disperser, a kneader, a three-roll mill, or the like, and then defoaming the resulting mixture.

The viscosity of the paste composition of the present embodiment may be not less than 20 Pa·s and not more than 300 Pa·s or may be not less than 40 Pa·s and not more than 200 Pa s.

The joint strength of the paste composition of the present embodiment may be not less than 25 MPa or may be not less than 30 MPa.

The viscosity and the joint strength may be measured by the methods described in Examples.

The paste composition of the present embodiment thus produced has excellent storage stability and oxidation resistance and can maintain high sinterability and joinability without being affected by the atmospheric exposure time before curing.

Semiconductor Device, Electrical Component, and Electronic Component Since a semiconductor device, an electrical component, and an electronic component of the present embodiment are joined by using the paste composition described above, their reliability is high.

The semiconductor device of the present embodiment is formed by joining a semiconductor element on a substrate serving as an element support member using the paste composition described above. That is, here, the paste composition is used as a die attach paste, and the semiconductor element and the substrate are joined and fixed to each other via the paste.

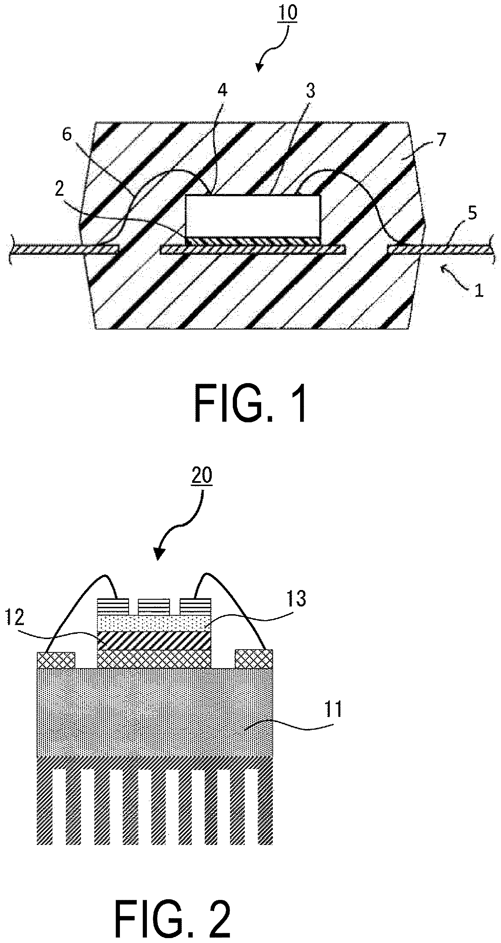

FIG. 1 is a cross-sectional view of a semiconductor device according to the present embodiment. A semiconductor device 10 is provided with a semiconductor element 3 on a lead frame 1 with a cured material 2 of a paste composition interposed between the semiconductor element and the lead frame. A bonding wire 6 connects an electrode 4 on the semiconductor element 3 and a lead 5 of the lead frame 1, and a cured material 7 of a sealing resin composition seals these members.

Here, the semiconductor element may be any known semiconductor element, and examples thereof include transistors and diodes. Examples of the semiconductor element further include wide bandgap semiconductor elements such as SiC and GaN; and light emitting elements such as LEDs. The type of light-emitting element is not particularly limited, and examples thereof include those in which a nitride semiconductor, such as InN, AlN, GaN, InGaN, AlGaN, or InGaAlN is formed as a light-emitting layer on a substrate by a method such as the MOBVC method.

Examples of the element support member include a support member made of a material such as copper, silver-plated copper, a pre-plating lead frame (PPF), glass epoxy, or ceramics.

Using the paste composition of the present embodiment makes a semiconductor device have good connection reliability with respect to a temperature cycle after mounting. Since the oxidation of the copper particles is small and the sinterability is stable, the semiconductor device also has an advantage of small temporal change in output and long life with long-time driving.

The electrical component and the electronic component of the present embodiment are formed by joining a heat dissipation member to a heat generation member using the paste composition. That is, the paste composition is used as a material for joining heat dissipation members, and the heat dissipation member and the heat generation member are joined and fixed to each other via the paste composition.

FIG. 2 is a cross-sectional view of an electrical component according to the present embodiment. An electrical component 20 is provided with a heat generation member 13 on a heat dissipation member 11 with a cured material 12 of a paste composition interposed between the heat generation member and the heat dissipation member.

The heat generation member may be the semiconductor element or a member having the semiconductor element, or may be another heat generation member. Examples of the heat-generating member other than the semiconductor element include optical pickups and power transistors. In addition, examples of the heat-dissipating member include heat sinks and heat spreaders.

Joining the heat dissipation member to the heat generation member in this manner using the paste composition can efficiently release the heat generated in the heat generation member to the outside with the heat dissipation member and can reduce the temperature rise of the heat generation member. The heat generation member and the heat dissipation member may be directly joined to each other with the paste composition, or may be indirectly joined to each other with another member having high thermal conductivity interposed therebetween.

EXAMPLES

The present disclosure will be specifically described through examples; however, the present disclosure is not limited in any way to these examples.

Synthesis of Carboxylic Acid Amine Salt

Preparation Example 1

In a 50 mL sample bottle, 40 mmol of nonanoic acid (trade name: nonanoic acid, available from Tokyo Chemical Industry Co., Ltd.) and 40 mmol of hexylamine (trade name: hexylamine, available from Tokyo Chemical Industry Co., Ltd.) were put, then stirred and mixed at 60°C for 15 minutes in an aluminum block type heating stirrer, thereafter cooled to the room temperature (25°C), whereby a hexylamine salt of nonanoic acid (yield 10.3 g, yield rate 99.2%) was produced.

Preparation Example 2

In a 50 mL sample bottle, 40 mmol of octanoic acid (trade name: octanoic acid, available from Tokyo Chemical Industry Co., Ltd.) and 40 mmol of 2-amino-1-propanol (trade name : 2-amino-1-propanol, available from Tokyo Chemical Industry Co., Ltd.) were put, then stirred and mixed at 60°C for 15 minutes in an aluminum block type heating stirrer, thereafter cooled to the room temperature (25°C), whereby a 2-aminopropanol salt of octanoic acid (yield 8.7 g, yield rate 98.7%) was produced.

Preparation Example 3

In a 50 mL sample bottle, 40 mmol of decanoic acid (trade name: decanoic acid, available from Tokyo Chemical Industry Co., Ltd.) and 40 mmol of octylamine (trade name: n-octylamine, available from Tokyo Chemical Industry Co., Ltd.) were put, then stirred and mixed at 60°C for 15 minutes in an aluminum block type heating stirrer, thereafter cooled to the room temperature (25°C), whereby an octylamine salt of decanoic acid (yield 12.01 g, yield rate 99.6%) was produced.

Production of First Copper Particle

Synthesis Example 1

In a 50 mL sample bottle, 20 mmol of a copper (II) acetate monohydrate (trade name: copper (II) acetate monohydrate, available from Tokyo Chemical Industry Co., Ltd.) as a copper compound, 40 mmol of the hexylamine salt of nonanoic acid prepared in Preparation Example 1, and 3 mL of 1-propanol (manufactured by Tokyo Chemical Industry Co., Ltd.) as an organic solvent were put, and mixed at 90°C for 5 minutes in an aluminum block type heating stirrer, whereby a copper precursor solution was produced. After the copper precursor solution was cooled to the room temperature (25°C), a solution prepared by dissolving 20 mmol of hydrazine monohydrate (trade name: hydrazine monohydrate, available from FUJIFILM Wako Pure Chemical Corporation) as the reducing compound in 3 mL of 1-propanol was added to the copper precursor solution in the sample bin, and the mixture was stirred for 5 minutes.

The mixture was heated and stirred again with the aluminum block type heating stirrer at 90°C for 1 hour. After the mixture was cooled to the room temperature (25°C), the mixture was centrifuged (5000 rpm, 5 minutes) to form a copper cake. To the copper cake, 30 mL of ethanol (special grade, available from KANTO CHEMICAL CO., INC.) was added. The resulting material was subjected to redispersion by shaking and centrifugation (5000 rpm, 5 min). This operation was repeated 4 times. Thereafter, the same operation was repeated twice except that ethanol was changed to diethylene glycol (available from Tokyo Chemical Industry Co., Ltd.), whereby a solid was produced. The resulting solid was dried under reduced pressure to produce copper particles 1 (yield 0.31 g, yield rate 97.8%) in a powder form with copper brightness. The resulting copper particles 1 were analyzed. The oxidation degree was 1.6%, the median diameter was 95 nm, the crystallite diameter was 51 nm, and the mass coverage was 1.9%.

Synthesis Example 2

Copper particles 2 (yield 0.30 g, yield rate 94.6%) were produced in the same manner as in Synthesis Example 1 except that the copper (II) acetate monohydrate was changed to copper (I) oxide (trade name: R, available from Furukawa Chemicals Co., Ltd.), and the hexylamine salt of nonanoic acid was changed to the 2-aminopropanol salt of octanoic acid prepared in Preparation Example 2. The resulting copper particles 2 were analyzed. The oxidation degree was 0.9%, the median diameter was 105 nm, the crystallite diameter was 56 nm, and the mass coverage was 1.9%.

Synthesis Example 3

Copper particles 3 (yield 0.26 g, yield rate 82.0%) were produced in the same manner as in Synthesis Example 1 except that the heating time at 90°C after the hydrazine monohydrate was added was changed from 1 hour to 10 minutes. The resulting copper particles 3 were analyzed. The oxidation degree was 1.9%, the median diameter was 80 nm, the crystallite diameter was 39 nm, and the mass coverage was 2.5%.

Synthesis Example 4

Copper particles 4 (yield 0.31 g, yield rate 97.8%) were produced in the same manner as in Synthesis Example 1 except that the organic solvent was changed to 1,3-propanediol (available from Tokyo Chemical Industry Co., Ltd.) and the conditions to heat the material after the hydrazine monohydrate was added was changed from 90°C for 1 hour to 110°C for 3 hours. The resulting copper particles 4 were analyzed. The oxidation degree was 0.7%, the median diameter was 115 nm, the crystallite diameter was 90 nm, and the mass coverage was 2.2%.

Synthesis Example 5

Copper particles 5 (yield 0.31 g, yield rate 97.8%) were produced in the same manner as in Synthesis Example 1 except that nitrogen purge was performed at the time of dispersion by shaking with ethanol and with ethylene glycol. The resulting copper particles 5 were analyzed. The oxidation degree was 0.02%, the median diameter was 95 nm, the crystallite diameter was 51 nm, and the mass coverage was 2.1%.

Synthesis Example 6

Copper particles 6 (yield 0.31 g, yield rate 97.8%) were produced in the same manner as in Synthesis Example 1 except that air bubbling was performed for 1 minute before the dispersion by shaking with ethanol and the dispersion by shaking with ethylene glycol. The resulting copper particles 6 were analyzed. The oxidation degree was 2.8%, the median diameter was 95 nm, the crystallite diameter was 51 nm, and the mass coverage was 2.2%.

Synthesis Example 7

Copper particles 7 (yield 0.31 g, yield rate 97.8%) were produced in the same manner as in Synthesis Example 1 except that washing with ethanol was performed twice. The resulting copper particles 7 were analyzed. The oxidation degree was 1.1%, the median diameter was 95 nm, the crystallite diameter was 51 nm, and the mass coverage was 5.2%.

Synthesis Example 8

Copper particles 8 (yield 0.30 g, yield rate 94.6%) were produced in the same manner as in Synthesis Example 1 except that the hexylamine salt of nonanoic acid was changed to the octylamine salt of decanoic acid prepared in Preparation Example 3. The resulting copper particles 8 were analyzed. The oxidation degree was 7.5%, the median diameter was 30 nm, the crystallite diameter was 15 nm, and the mass coverage was 6.8%

Examples 1 to 8 and Comparative Examples 1 and 2

The components of the types and blending amounts listed in Table 1 were mixed and kneaded with a roll to produce paste compositions.

Details of each component described in Table 1 used for preparation of the paste compositions are as follows.

First Copper Particle

· Copper particles 1: Copper particles produced in Synthesis Example 1 (oxidation degree 1.6%, median diameter 95 nm, crystallite diameter 51 nm)
· Copper particles 2: Copper particles produced in Synthesis Example 2 (oxidation degree 0.9%, median diameter 105 nm, crystallite diameter 56 nm)
· Copper particles 3: Copper particles produced in Synthesis Example 3 (oxidation degree 1.9%, median diameter 80 nm, crystallite diameter 39 nm)
· Copper particles 4: Copper particles produced in Synthesis Example 4 (oxidation degree 0.7%, median diameter 115 nm, crystallite diameter 90 nm)
· Copper particles 5: Copper particles produced in Synthesis Example 5 (oxidation degree 0.02%, median diameter 95 nm, crystallite diameter 51 nm)
· Copper particles 6: Copper particles produced in Synthesis Example 6 (oxidation degree 2.8%, median diameter 95 nm, crystallite diameter 51 nm)
· Copper particles 7: Copper particles produced in Synthesis Example 7 (oxidation degree 1.1%, median diameter 95 nm, crystallite diameter 51 nm)
· Copper particles 8: Copper particles produced in Synthesis Example 8 (oxidation degree 7.5%, median diameter 30 nm, crystallite diameter 15 nm)

Second Copper Particle

· Copper particles 9 : 1300Y (trade name, available from Mitsui Mining & Smelting Co., Ltd.; median diameter: 3.9 μm, crystallite diameter: 102 nm)

Phosphoric Acid Ester

· Phosphoric acid ester 1 : Copolymer product (trade name: DIPERBYK (registered trademark)-102, available from BYK-Chemie; acid value: 101 mgKOH/g)
· Phosphoric acid ester 2: alkylolammonium salt of copolymer product (trade name: DIPERBYK (registered trademark)-180, available from BYK-Chemie; amine value: 94 mgKOH/g, acid value: 94 mgKOH/g)
· Phosphoric acid ester 3: copolymer product (trade name: DIPERBYK (registered trademark)-111, available from BYK-Chemie; acid value: 129 mgKOH/g)

Organic Solvent

· Diethylene glycol: available from Tokyo Chemical Industry Co., Ltd.

Evaluation Method

Method for Evaluating Copper Particle

Crystallite Diameter

The copper cake produced in each synthesis example was applied onto a glass to have a thickness of 500 $\mu$m, and the crystalline diameter was calculated from the Scherrer equation with respect to the plane index (111) plane peak by a concentration method using a CuK$\alpha$ ray as a radiation source with an X-ray diffractometer (trade name: SmartLab SE, manufactured by Rigaku Corporation). The Scherrer constant used was 1.33.

Median Diameter

The copper cake produced in each synthesis example was applied onto a glass to have a thickness of 500 $\mu$m, and the median diameter was calculated as a median of area equivalent circle diameters of 2000 copper particles extracted from an image photographed under the conditions of an acceleration voltage of 15 kV and 50000 times by a scanning electron microscope (SEM, trade name: JSM-F100, available from JEOL Ltd.).

Oxidation Degree

The copper cake produced in each synthesis example was applied onto a glass to have a thickness of 500 $\mu$m, and data collected by a concentration method using a CuK$\alpha$ ray as a radiation source using an X-ray diffractometer (product name : SmartLab SE, manufactured by Rigaku Corporation) was analyzed by the Rietveld method to determine a quantitative value.

Mass Coverage

The mass coverages of the copper particles 1 to 8 were measured by the following operation. After the copper particles were washed four times with ethanol, the mass of each resulting copper cake was measured and taken as a mass (M1) of the copper particles before heating. Next, the copper cake was heated to 600°C in a nitrogen gas atmosphere with an infrared ray heating device (product name: MIRA-700AR, available from ADVANCE RIKO, Inc.), and the mass of the copper cake after heating was measured. This mass was taken as a mass (M2) of the copper particles after heating, and the mass coverage was calculated from the following formula (1).

$$\text{Mass coverage (\%)} = (M1 - M2)/M1 \times 100 \ (1)$$

Method for Evaluating Paste Composition

Viscosity (Initial Viscosity)

The values at 25°C and 5 rpm was measured with an E-type viscometer (trade name: VISCOMETER-TV22, available from Toki Sangyo Co., Ltd., applied cone-plate rotor: 3° $\times$ R17.65).

Storage Stability (Pot Life)

The number of days taken for each paste composition left standing in a constant-temperature bath at 25°C to have an increased viscosity not less than 0.7 times the initial viscosity was measured.

Sinterability (Coating Film)

Each paste composition was applied to a glass substrate (thickness: 1 mm) by a screen printing method to have a thickness of 25 $\mu$m and cured at 200°C for 60 minutes. The volume resistivity ($\Omega \cdot$cm) of the resulting sintered film was measured by a four-point probe method using Loresta GP (trade name, available from Mitsubishi Chemical Analytech Co., Ltd.). The smaller the volume resistivity ($\Omega \cdot$cm), the better the sinterability.

Sinterability After Atmospheric Exposure

Each paste composition formed into a coating film having a thickness of 500 $\mu$m with a squeegee was stored in an incubator at 25°C for 24 hours, and then baked at 200°C for 1 hour under a nitrogen (3% hydrogen) atmosphere, and the volume resistivity ($\Omega \cdot$cm) was measured by a four-point probe method using Loresta GP (available from Mitsubishi Chemical Analytech Co., Ltd.). The smaller the volume resistivity ($\Omega$cm), the better the sinterability.

Total Content of Amine Compound (a) and Carboxylic Acid Amine Salt (b)

Each paste composition was separated into a liquid component and a solid component by a centrifugal separation method, and then a quantitative value of the liquid component was determined by an internal standard method using a gas chromatography mass spectrometer (trade name: GCMS QP-2010, available from Shimadzu Corporation).

Method for Evaluating Semiconductor Device

Production of Joint Strength Test Piece

A silicon chip provided with a gold sputtering layer on a joining surface of 2 mm × 2 mm was mounted on a pure copper frame and PPF (Ni-Pd/Au-plated copper frame) using each paste composition, and the paste composition was cured under conditions of 200°C and 60 minutes in a nitrogen (3% hydrogen) atmosphere. At this time, a cured material cured immediately after mounting and a cured material cured after atmospheric exposure for 24 hours were produced.

Joint Strength

For the cured material cured immediately after mounting, the die shear strength at room temperature (25°C) was measured using DAGE 4000 Plus (trade name, available from Nordson Corporation) after curing and after a moisture absorption treatment (85°C, relative humidity 85%, 72 hours), respectively. For the cured material cured after atmospheric exposure for 24 hours, the die shear strength was measured in the same manner as described above.

[Table 1]

Table 1

| | | | Example 1 | Example 2 | Example 3 | Example 4 | Example 5 | Example 6 | Example 7 | Example 8 | Comparative Example 1 | Comparative Example 2 |
|---|---|---|---|---|---|---|---|---|---|---|---|---|
| First copper particles | Copper particles 1 | Parts by mass | 40 | - | - | - | - | - | 40 | 40 | - | - |
| | Copper particles 2 | Parts by mass | - | 40 | - | - | - | - | - | - | - | - |
| | Copper particles 3 | Parts by mass | - | - | 40 | - | - | - | - | - | - | - |
| | Copper particles 4 | Parts by mass | - | - | - | 40 | - | - | - | - | - | - |
| | Copper particles 5 | Parts by mass | - | - | - | - | 40 | - | - | - | - | - |
| | Copper particles 6 | Parts by mass | - | - | - | - | - | 40 | - | - | - | - |
| | Copper particles 7 | Parts by mass | - | - | - | - | - | - | - | - | 40 | - |
| | Copper particles 8 | Parts by mass | - | - | - | - | - | - | - | - | - | 40 |
| Second copper particles | Copper particles 9 | Parts by mass | 60 | 60 | 60 | 60 | 60 | 60 | 60 | 60 | 60 | 60 |
| Solvent | Diethylene glycol | Parts by mass | 15 | 15 | 15 | 15 | 15 | 15 | 15 | 15 | 15 | 15 |
| Phosphoric acid ester | Phosphoric acid ester 1 | Parts by mass | 1 | 1 | 1 | 1 | 1 | 1 | - | - | 1 | 1 |
| | Phosphoric acid ester 2 | Parts by mass | - | - | - | - | - | - | 1 | - | - | - |
| | Phosphoric acid ester 3 | Parts by mass | - | - | - | - | - | - | - | 1 | - | - |
| Viscosity (initial viscosity) | | Pas | 70 | 65 | 80 | 55 | 95 | 70 | 70 | 70 | 70 | 220 |

14

| | | Parts by mass | Example 1 | Example 2 | Example 3 | Example 4 | Example 5 | Example 6 | Example 7 | Example 8 | Comparative Example 1 | Comparative Example 2 |
|---|---|---|---|---|---|---|---|---|---|---|---|---|
| Storage stability | | SUNDAY | >7 | >7 | >7 | >7 | >7 | >7 | >7 | >7 | >7 | >7 |
| Sinterability (coating film) | | $\Omega \cdot m$ | $7.6 \times 10^{-6}$ | $3.6 \times 10^{-6}$ | $8.8 \times 10^{-6}$ | $4.0 \times 10^{-6}$ | $2.6 \times 10^{-6}$ | $2.2 \times 10^{-5}$ | $7.2 \times 10^{-6}$ | $7.5 \times 10^{-6}$ | $2.2 \times 10^{-3}$ | $6.1 \times 10^{-2}$ |
| Sinterability after atmospheric exposure | | $\Omega \cdot m$ | $7.8 \times 10^{-6}$ | $4.9 \times 10^{-6}$ | $1.2 \times 10^{-5}$ | $4.2 \times 10^{-6}$ | $4.8 \times 10^{-6}$ | $2.3 \times 10^{-5}$ | $7.4 \times 10^{-6}$ | $9.0 \times 10^{-6}$ | $1.2 \times 10^{-2}$ | $7.0 \times 10^{-2}$ |
| Total content of amine compound (a) and carboxylic acid amine salt (b) | | mass% | 0.18 | 0.21 | 0.18 | 0.20 | 0.22 | 0.21 | 0.18 | 0.18 | 1.50 | 1.27 |
| Joint strength | PPF (after curing) | MPa | 50 | 57 | 49 | 54 | 65 | 42 | 51 | 50 | 25 | 11 |
| | PPF (after atmospheri c exposure) | MPa | 46 | 49 | 40 | 50 | 49 | 41 | 46 | 42 | 10 | 10 |
| | PPF (after moisture absorption treatment) | MPa | 51 | 57 | 48 | 54 | 64 | 42 | 51 | 50 | 25 | 11 |
| | Copper frame (after curing) | MPa | 55 | 61 | 52 | 56 | 68 | 43 | 56 | 56 | 23 | 12 |
| | Copper frame (after atmospheri c exposure) | MPa | 53 | 58 | 42 | 52 | 56 | 41 | 54 | 45 | 9 | 11 |
| | Copper frame (after moisture absorption treatment) | MPa | 55 | 60 | 52 | 56 | 68 | 43 | 55 | 55 | 22 | 12 |

EP 4 309 828 A1

It is found that Examples 1 to 8 in which the total content of the amine compound (a) and the carboxylic acid amine salt (b) detected from the paste composition is less than 1 mass% have high oxidation resistance and can maintain high sinterability and joinability without being affected by the atmospheric exposure time before curing.

REFERENCE SIGNS

    10 Semiconductor device
    20 Electrical component
    1 Lead frame
    2, 12 Cured material of paste composition
    3 Semiconductor element
    4 Electrode
    5 Lead
    6 Bonding wire
    7 Cured material of sealing resin composition
    11 Heat dissipation member
    13 Heat generation member

**Claims**

1. A paste composition comprising first copper particles, wherein

   the first copper particles are formed by covering copper particles serving as a base material with at least one type of compound selected from the group consisting of an amine compound (a) and a carboxylic acid amine salt (b), and
   a total content of the amine compound (a) and the carboxylic acid amine salt (b) detected in the paste composition is less than 1 mass% of an entire amount of the paste composition.

2. The paste composition according to claim 1, wherein the first copper particles have a median diameter not less than 50 nm and not more than 500 nm and a crystallite diameter not less than 30 nm and not more than 150 nm.

3. The paste composition according to claim 1 or 2, wherein the first copper particles have an oxidation degree not less than 0.01% and not greater than 3.0%.

4. The paste composition according to any one of claims 1 to 3, further comprising second copper particles having a median diameter not less than 1 $\mu$m and not more than 8 $\mu$m and a crystallite diameter not less than 70 nm and not more than 140 nm.

5. The paste composition according to any one of claims 1 to 4, further comprising a phosphoric acid ester.

6. The paste composition according to claim 5, wherein the phosphoric acid ester has an acid value and an amine value each being not greater than 130 mgKOH/g.

7. The paste composition according to claim 5 or 6, wherein a ratio of the acid value to the amine value [acid value/amine value] of the phosphoric acid ester is not less than 0 and not more than 1.5.

8. A semiconductor device joined by using the paste composition described in any one of claims 1 to 7.

9. An electrical component joined by using the paste composition described in any one of claims 1 to 7.

10. An electronic component joined by using the paste composition described in any one of claims 1 to 7.

FIG. 1

FIG. 2

<table>
<tr><td colspan="2" align="center">INTERNATIONAL SEARCH REPORT</td><td>International application No.<br><br>**PCT/JP2022/011246**</td></tr>
</table>

**A. CLASSIFICATION OF SUBJECT MATTER**

***B22F 1/102***(2022.01)i; ***B22F 1/00***(2022.01)i; ***B22F 7/08***(2006.01)i; ***B22F 9/00***(2006.01)i; ***C09K 5/14***(2006.01)i;
***H01B 1/00***(2006.01)i; ***H01B 1/22***(2006.01)i
FI: B22F1/102; B22F1/00 L; B22F7/08 C; B22F9/00 B; C09K5/14 E; H01B1/00 M; H01B1/22 A

According to International Patent Classification (IPC) or to both national classification and IPC

**B. FIELDS SEARCHED**

Minimum documentation searched (classification system followed by classification symbols)

B22F1/102; B22F1/00; B22F7/08; B22F9/00; C09K5/14; H01B1/00; H01B1/22

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X | JP 2015-210973 A (DAINIPPON PRINTING CO., LTD.) 24 November 2015 (2015-11-24) claims, paragraphs [0021]-[0047] | 1, 5-7 |
| Y | | 1-10 |
| X | JP 2015-517184 A (DONGJIN SEMICHEM CO., LTD.) 18 June 2015 (2015-06-18) claims, paragraphs [0018]-[0021] | 1 |
| Y | | 1-10 |
| Y | JP 2014-167145 A (OSAKA UNIVERSITY) 11 September 2014 (2014-09-11) claims, paragraphs [0021]-[0044] | 1-10 |
| Y | JP 2013-159830 A (TOYOTA CENTRAL R&D LABORATORIES., INC.) 19 August 2013 (2013-08-19) claims, paragraphs [0023]-[0033] | 1-10 |
| Y | JP 2017-123326 A (FURUKAWA ELECTRIC CO., LTD.) 13 July 2017 (2017-07-13) claims, paragraphs [0022]-[0041] | 1-10 |

✓ Further documents are listed in the continuation of Box C.     ✓ See patent family annex.

| | |
|---|---|
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| **06 May 2022** | **17 May 2022** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

**INTERNATIONAL SEARCH REPORT**

International application No.

**PCT/JP2022/011246**

C. DOCUMENTS CONSIDERED TO BE RELEVANT

| Category* | Citation of document, with indication, where appropriate, of the relevant passages | Relevant to claim No. |
|---|---|---|
| A | JP 2005-240088 A (SUMITOMO METAL MINING CO., LTD.) 08 September 2005 (2005-09-08) claims, paragraphs [0021]-[0029], table 1 | 1-10 |
| A | JP 2020-80317 A (DOWA ELECTRONICS MATERIALS CO.) 28 May 2020 (2020-05-28) paragraphs [0012]-[0029] | 1-10 |

Form PCT/ISA/210 (second sheet) (January 2015)

INTERNATIONAL SEARCH REPORT
Information on patent family members

International application No.

**PCT/JP2022/011246**

| Patent document cited in search report | | | Publication date (day/month/year) | Patent family member(s) | Publication date (day/month/year) |
|---|---|---|---|---|---|
| JP | 2015-210973 | A | 24 November 2015 | WO 2015/166755 A1 claims, paragraphs [0021]-[0047] | |
| JP | 2015-517184 | A | 18 June 2015 | WO 2013/147442 A1 claims, paragraphs [0032]-[0036] KR 10-2013-0110389 A CN 104221094 A | |
| JP | 2014-167145 | A | 11 September 2014 | (Family: none) | |
| JP | 2013-159830 | A | 19 August 2013 | (Family: none) | |
| JP | 2017-123326 | A | 13 July 2017 | DE 102017129945 A1 | |
| JP | 2005-240088 | A | 08 September 2005 | (Family: none) | |
| JP | 2020-80317 | A | 28 May 2020 | US 2018/0179409 A1 paragraphs [0012]-[0028] WO 2016/194289 A1 EP 3305441 A1 TW 201704369 A CN 107614160 A KR 10-2018-0016472 A | |

Form PCT/ISA/210 (patent family annex) (January 2015)

20

**EP 4 309 828 A1**

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2011240406 A
- JP 2014167145 A